# EUROPÄISCHE PATENTSCHRIFT

(11) **EP 2 791 631 B1**
(45) Veröffentlichungstag und Bekanntmachung des Hinweises auf die Patenterteilung: **14.08.2019**
(21) Anmeldenummer: 12801481.8
(22) Anmeldetag: 22.11.2012
(51) Int. Cl.: G01F 15/14, G01D 11/24, G01F 15/00, H05K 7/14, H05K 9/00

(54) **MESSUMFORMER**
MEASURING TRANSDUCER
CONVERTISSEUR DE MESURE

(30) Priorität: 12.12.2011 DE 102011088302
(43) Veröffentlichungstag der Anmeldung: 22.10.2014
(73) Patentinhaber: Endress+Hauser SE+Co. KG, 79689 Maulburg (DE)
(72) Erfinder: RUF, Klaus, 79618 Rheinfelden (DE); STIB, Ralph, 79677 Schönau (DE)
(74) Vertreter: Andres, Angelika Maria
(86) Internationale Anmeldenummer: PCT/EP2012/073316
(87) Internationale Veröffentlichungsnummer: WO 2013/087388

(56) Entgegenhaltungen:
- US-A- 5 546 804
- US-A1- 2006 055 006

## Beschreibung

Die vorliegende Erfindung betrifft einen Messumformer, insbesondere einen Messumformer zum Bereitstellen eines Messwerts mindestens einer Messgröße, insbesondere eines Prozessparameters eines Mediums an ein Leitsystem. Gängige Prozessparameter eines Mediums sind beispielsweise Absolut-, Relativ-, und Differenzdruck, Füllstand, Temperatur, Masse- oder Volumendurchfluss, Dichte, Zähigkeit, pH-Wert oder andere potentiometrische Messgrößen, Sauerstoffgehalt, elektrische Leitfähigkeit, Trübung, Summenparameter wie der Gesamtgehalt an organischem Kohlenstoff.

Gattungsgemäße Messumformer zum Bereitstellen eines Messwerts mindestens einer Messgröße an ein Leitsystem umfasst einen Sensor mit einem elektrischen Wandler zum Ausgeben eines vom aktuellen Wert der Messgröße abhängigen Primärsignals; eine erste elektronische Schaltung, zum Treiben des Wandlers, zum Verarbeiten des Primärsignals und zum Ausgeben eines von dem Primärsignal abhängigen Zwischensignals; eine zweite elektronische Schaltung zum Speisen der ersten elektronischen Schaltung und zum Verarbeiten des Zwischensignals zum Erzeugen eines den Messwert der Messgröße präsentierenden Signals, wobei die zweite elektronische Schaltung einen Signalausgang zum Ausgeben des Signals an Anschlussleitungen aufweist; eine Gehäuseanordnung, wobei die erste elektronische Schaltung mindestens einen ersten Schaltungsträger aufweist, und die zweite elektronische Schaltung mindestens einen zweiten Schaltungsträger aufweist, und wobei die erste und die zweite elektronische Schaltung beabstandet zueinander in der Gehäusebaugruppe positioniert sind. Häufig ist der Messumformer modular gestaltet, so dass die Gehäusebaugruppe ein erstes Modulgehäuse und ein zweites Modulgehäuse umfasst, wobei die beiden Modulgehäuse miteinander verbunden sind. Das erste Modulgehäuse enthält den Sensor und die erste elektronische Schaltung, während die zweite elektronische Schaltung in dem zweiten Modulgehäuse angeordnet sind. Das zweite Modulgehäuse enthält zudem einen so genannten Klemmenblock an den die Anschlussleitungen anzuschließen sind. Über die Anschlussleitungen können Hochfrequenzstörungen im Bereich von einigen 100 MHz in das zweite Modulgehäuse gelangen und über den Signalpfad die zweite und die erste elektronische Schaltung beeinträchtigen. Um dies zu vermeiden, ist beispielsweise das zweite Modulgehäuse als Zweikammergehäuse mit einer Trennwand ausgebildet, welche einen Anschlussraum, der den Klemmenblock enthält, von dem Elektronikraum trennt, in dem die zweite elektronische Schaltung angeordnet ist. In der metallischen Trennwand, die bereits als Schirmung wirkt, sind Hochfrequenzfilter vorgesehen, welche die HF-Signale bedämpfen sollen. Ein solcher Messumformer ist beispielsweise in der Offenlegungsschrift WO 96/05483 beschrieben. Die Herstellung eines Zweikammergehäuses ist jedoch verhältnismäßig teuer, da mindestens eine zusätzliche Gehäuseöffnung mit einem entsprechenden Gehäusedeckel vorzusehen ist. US 2006 0055006 offenbart einen ähnlichen Messumformer.

Es ist daher die Aufgabe der vorliegenden Erfindung eine einfachere Lösung zum Schutz vor Hochfrequenzstörungen bereitzustellen. Die Aufgabe wird erfindungsgemäß gelöst durch den Messumformer gemäß Anspruch 1.

Der erfindungsgemäße Messumformer zum Bereitstellen eines Messwerts mindestens einer Messgröße an ein Leitsystem umfasst einen Sensor mit einem elektrischen Wandler zum Ausgeben eines vom aktuellen Wert der Messgröße abhängigen Primärsignals; eine erste elektronische Schaltung, zum Treiben des Wandlers, zum Verarbeiten des Primärsignals und zum Ausgeben eines von dem Primärsignal abhängigen Zwischensignals; eine zweite elektronische Schaltung zum Speisen der ersten elektronischen Schaltung und zum Verarbeiten des Zwischensignals zum Erzeugen eines den Messwert der Messgröße präsentierenden Signals, wobei die zweite elektronische Schaltung einen Signalausgang zum Ausgeben des Signals an Anschlussleitungen aufweist; eine Gehäuseanordnung, welche mindestens einen metallischen Werkstoff aufweist, wobei die erste elektronische Schaltung mindestens einen ersten Schaltungsträger aufweist, und die zweite elektronische Schaltung mindestens einen zweiten Schaltungsträger aufweist, und wobei die erste und die zweite elektronische Schaltung beabstandet zueinander in der Gehäusebaugruppe positioniert sind; und eine elektrisch leitende Schirmung und Hochfrequenzfilter zum Schutz vor HF-Störungen, die über die Anschlussleitungen in die Gehäuseanordnung eindringen können; wobei erfindungsgemäß die elektrisch leitende Schirmung und die Hochfrequenzfilter zwischen dem ersten Schaltungsträger und dem zweiten Schaltungsträger angeordnet sind. Der metallische Werkstoff der Gehäuseanordnung kann Stahl, insbesondere Edelstahl, Aluminium und/oder beliebige Legierungen umfassen. Die Gehäuseanordnung kann einstückig oder modular mit mehreren Modulgehäusen aufgebaut sein. Die Gehäuseanordnung kann insbesondere Drehteile, Gussteile und/oder Tiefziehteile umfassen.

Gemäß der Erfindung umfasst die Schirmung einen elektrisch isolierenden Schirmträger mit einer metallischen Schirmschicht, wobei der Hochfrequenzfilter durch die Schirmschicht von der zweiten elektronischen Schaltung getrennt ist.

Gemäß der Erfindung weist der der Schirmträger mindestens eine Durchkontaktierung auf, über welche die zweite elektronische Schaltung mit der ersten elektronischen Schaltung verbunden ist, wobei mindest eine der elektrischen Durchkontaktierungen von der metallischen Schirmschicht galvanisch getrennt und ringförmig umgeben ist.

In einer Weiterbildung der Erfindung weist die Schirmung mindestens eine elektrisch leitende Hülse auf, welche die mindestens eine elektrische Durchkontaktierung umgibt, von der Durchkontaktierung galvanisch getrennt und mit der Schirmschicht im galvanischen Kontakt ist, wobei die Hülse insbesondere in den Schirmträger eingebettet ist.

Gemäß der Erfindung beträgt die Kapazität zwischen der mindestens einen Durchkontaktierung und der Schirmung beträgt nicht mehr als 1 nf. Durch diese Beschränkung der Kapazität ist zwar einerseits die Wirkung der Schirmung begrenzt, andererseits kann damit die in der Kapazität gespeicherte Energie so weit limitiert werden, dass der Messumformer beispielsweise die Zündschutzart "eigensicher" bzw. "Ex-i" einhält.

In einer Weiterbildung der Erfindung ist der mindestens eine Hochfrequenzfilter an dem Schirmträger angeordnet, wobei die erste elektronische Schaltung über den Hochfrequenzfilter mit der elektrischen Durchkontaktierung verbunden ist, wobei der Abstand des Hochfrequenzfilters von der Durchkontaktierung nicht mehr als 2 cm, vorzugsweise nicht mehr al 1,5 cm und besonders bevorzugt nicht mehr als 1 cm beträgt.

In einer Weiterbildung der Erfindung ist der Schirmträger ein separates, plattenförmiges Bauteil, welches in die Gehäuseanordnung eingebaut ist.

Die Schirmung kann gemäß einer Weiterbildung insbesondere als Leiterlatte (PCB) gefertigt werden und - abgesehen von den Bereichen der Durchkontaktierungen - eine vorzugsweise geschlossene Metallisierung umfassen, wobei der isolierende Grundkörper der Leiterplatte den Schirmträger bildet.

In einer Weiterbildung der Erfindung weist die Gehäuseanordnung einen Innenraum auf, der in einer Ebene, in welcher die Schirmung angeordnet ist, eine lichte Querschnittsfläche aufweist, die zu nicht weniger als 75% vorzugsweise nicht weniger als 80% weiter bevorzugt nicht weniger als 90% und besonders bevorzugt mindestens 98% von der Schirmung abgedeckt ist.

In einer Weiterbildung der Erfindung liegt die metallische Schirmschicht auf dem Potential des elektrisch leitenden Materials des Gehäuses.
In einer Weiterbildung der Erfindung umfasst der mindestens eine Hochfrequenzfilter mindestens ein LC-Glied.

In einer Weiterbildung der Erfindung weist die Gehäuseanordnung ein erstes Modulgehäuse und ein zweites Modulgehäuse auf, die miteinander verbunden sind, wobei das erste Modulgehäuse den Sensor und die erste elektronische Schaltung enthält, wobei das zweite Modulgehäuse die zweite elektronische Schaltung und die Schirmung enthält, wobei das zweite Modulgehäuse eine Öffnung aufweist, über welche die erste elektronische Schaltung mit der zweiten elektronischen Schaltung verbunden ist.

Die Schirmung kann in dem ersten Modulgehäuse oder in dem zweiten Modulgehäuse angeordnet sein.

In einer Weiterbildung der Erfindung ragt ein Endabschnitt des ersten Modulgehäuses in die Öffnung des zweiten Modulgehäuses hinein und ist mit einem die Öffnung umgebenden Halsbereich des zweiten Modulgehäuses verbunden.

In einer Weiterbildung der Erfindung weist der Endabschnitt eine elektrische Durchführung auf, über welche die erste elektronische Schaltung mit der zweiten elektronischen Schaltung verbunden ist, wobei die elektrische Durchführung welche hermetisch dicht ist.

In einer Weiterbildung der Erfindung bilden die Gehäuseanordnung und die Schirmschicht einen Faradayschen Käfig um die erste elektronische Schaltung.

In einer Weiterbildung der Erfindung umfasst der Sensor, einen Drucksensor, einen Füllstandssensor, einen Temperatursensor, einen Durchflusssensor, einen Feuchtesensor, einen Dichtesensor, einen Zähigkeitssensor, einen Leitfähigkeitssensor, einen potentiometrischen Sensor, einen amperometrischen Sensor, oder einen optischen Sensor.

Die Erfindung wird nun anhand des in den Zeichnungen dargestellten Ausführungsbeispiels erläutert. Es zeigt:

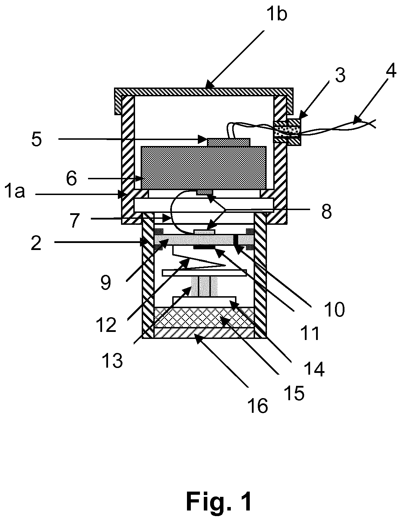

- Fig. 1:: einen schematischen Längsschnitt durch ein Ausführungsbeispiel eines erfindungsgemäßen Messumformers.

Das in Fig.1 dargestellte Ausführungsbeispiel eines erfindungsgemäßen Messumformers ist ein Druckmessumformer mit einem metallischen Elektronikgehäuse 1a, welches als Gussteil gefertigt ist, und mit einem metallischen Deckel 1b verschlossen ist. Das Elektronikgehäuse 1b ist auf ein metallisches Sensorgehäuse 2 aufgesetzt, welches insbesondere Edelstahl aufweist. Der Messumformer umfasst eine Anschlussmuffe 3 in einer Mantelfläche des Elektronikgehäuses 1a, welches im wesentlichen eine zylindrische Form aufweist, wobei durch die Anschlussmuffe 3 Versorgungs- und Signalleitungen 4 in das Elektronikgehäuse 1a geführt sind, um den Messumformer mit Energie zu versorgen und dessen Messsignale weiterzuleiten.

Die Versorgungs- und Signalleitungen 4 sind über einen Klemmenblock 5 an eine so genannte Hauptelektronik 6 des Messumformers angeschlossen, welche der zweiten elektronischen Schaltung gemäß der Definition der Erfindung entspricht. Die Hauptelektronik 6 ist wiederum mittels einer Verbindungsleitung 7 und Steckverbinder 8 an die Schirmanordnung 9 angeschlossen. Die Schirmanordnung umfasst eine Leiterplatte umfasst, die in einem dem Elektronikgehäuse 1a zugewandten Endabschnitt des im wesentlichen zylindrischen Sensorgehäuses 2 angeordnet und auf einer ersten, dem Elektronikgehäuse 1a zugewandten Seite bis auf den Bereich von Durchkontaktierungen 10 im wesentlichen vollständig metallisiert ist, und mit dem Sensorgehäuse 2 im galvanischen Kontakt steht. Auf einer zweiten, dem Elektronikgehäuse 1a abgewandten Seite der Leiterplatte 9 sind HF-Filter 11 angeordnet, die einerseits an die Durchkontaktierungen 10 und andererseits an einen so genannten Flexverbinder 12 angeschlossen sind, wobei der Flexverbinder 12 über einen Steckverbinder 13 an eine so genannte Sensorelektronik 14 angeschlossen ist, welche der ersten elektronischen Schaltung gemäß der Definition der Erfindung entspricht. An einer, dem Elektronikgehäuse 1a abgewandten, stirnseitigen Öffnung der Sensorgehäuses ist ein Drucksensor, beispielsweise ein Drucksensor mit einem keramischen Grundkörper 15 und einer keramischen Messmembran 16, die mit dem Grundkörper druckdicht verbunden ist, wobei der Drucksensor einen kapazitiven Wandler umfasst, der eine erste Elektrode an der dem Grundkörper zugewandten Seite der Messmembran 16 und mindestens eine zweite Elektrode an der der Messemembran zugewandten Seite des Grundkörpers 15 aufweist. Die erste Elektrode erstreckt sich vorzugsweise über die gesamte Fläche der Messmembran 16 und steht beispielsweise mit dem Sensorgehäuse im galvanischen Kontakt. Die Kapazität zwischen der ersten Elektrode und der zweiten Elektrode ist ei Maß für einen an der Außenseite der Messmembran 16 anstehenden Druck.
Die Sensorelektronik 14 ist auf der der Messmembran abgewandten Rückseite des Grundkörpers 15 angeordnet. Sie treibt den kapazitiven Wandler, und stellt ein insbesondere digitalisiertes Zwischensignal bereit, welches über den Flexleiter 12, die HF-Filter 11, die Durchkontaktierungen 10 und die Verbindungsleitung 7 an die Hauptelektronik 6 übertragen wird.

Die Hauptelektronik bereitet das Zwischensignal auf und erzeugt ein Ausgabesignal, welches den Messwert repräsentiert, beispielsweise ein analoges 4 ... 20 mA Stromsignal, welches über die Anschlussleitungen 4 ausgegeben wird.

Wenngleich über die Anschlussleitungen HF-Störungen in das Elektronikgehäuse 1a gelangen können, die von der Hauptelektronik 6 toleriert werden, verhindert die Schirmanordnung mit der metallisierten Leiterplatte 9 und den HF-Filtern 11, dass die empfindlichere Sensorelektronik, welche sehr schwache analoge Signale zu verarbeiten hat, durch die HF-Störungen beeinträchtigt wird.

Die Leiterplatte 9 weist beispielsweise eine Stärke von etwa 1, 5 mm auf, wobei die Durchkontaktierungen 10 im wesentlichen senkrecht zur Ebene der Leiterplatte verlaufen. Die Metallisierung der Leiterplatte 9 weist für jede Durchkontaktierung 10 einen Durchbruch mit einem Radius von beispielsweise 3,5 mm auf, wobei eine hülsenförmige Ringelektrode mit dem Radius des Durchbruchs koaxial um die Durchkontaktierung 10 über eine Länge von mindestens 50%, vorzugsweise nicht weniger als 75% der Leiterplattenstärke in die Leiterplatte geführt ist um die Durchkontaktierung gegen HF-Störungen zu schirmen. Der Radius der Ringelektrode von beispielsweise 3,5 mm ist so gewählt, dass die Kapazität zwischen der Ringelektrode und dem Leiter der Durchkontaktierung 10 mit der Zündschutzart "eigensicher" (Ex-i) vereinbar ist.

## Patentansprüche

1. Messumformer zum Bereitstellen eines Messwerts mindestens einer Messgröße an ein Leitsystem, umfassend:
einen Sensor (15, 16)mit einem elektrischen Wandler zum Ausgeben eines vom aktuellen Wert der Messgröße abhängigen Primärsignals;
eine erste elektronische Schaltung (14), zum Treiben des Wandlers, zum Verarbeiten des Primärsignals und zum Ausgeben eines von dem Primärsignal abhängigen Zwischensignals;
eine zweite elektronische Schaltung (6) zum Speisen der ersten elektronischen Schaltung und zum Verarbeiten des Zwischensignals zum Erzeugen eines den Messwert der Messgröße präsentierenden Signals, wobei die zweite elektronische Schaltung einen Signalausgang zum Ausgeben des Signals an Anschlussleitungen aufweist;
eine Gehäuseanordnung (1a, 1b, 2), welche mindestens einen elektrisch leitenden Werkstoff aufweist, insbesondere einen metallischen Werkstoff,
wobei die erste elektronische Schaltung (14) mindestens einen ersten Schaltungsträger aufweist, und die zweite elektronische Schaltung mindestens einen zweiten Schaltungsträger aufweist, und wobei die erste und die zweite elektronische Schaltung beabstandet zueinander in der Gehäuseanordnung (1a, 1b, 2) positioniert sind; und
eine elektrisch leitende Schirmung (9) und Hochfrequenzfilter (11) zum Schutz vor HF-Störungen, die über die Anschlussleitungen (4) in die Gehäuseanordnung (1a, 1b, 2) eindringen können;
wobei die elektrisch leitende Schirmung (9) und die Hochfrequenzfilter (11) zwischen dem ersten Schaltungsträger und dem zweiten Schaltungsträger angeordnet sind,
wobei die Schirmung einen elektrisch isolierenden Schirmträger mit einer metallischen Schirmschicht umfasst, und wobei der Hochfrequenzfilter durch die Schirmschicht von der zweiten elektronischen Schaltung getrennt ist,
wobei der Schirmträger mindestens eine Durchkontaktierung aufweist, über welche die zweite elektronische Schaltung mit der ersten elektronischen Schaltung verbunden ist, wobei mindest eine der elektrischen Durchkontaktierungen (10) von der metallischen Schirmschicht galvanisch getrennt und ringförmig umgeben ist,
wobei die Kapazität zwischen der Durchkontaktierung und der Schirmung nicht mehr als 1 nf beträgt,
wobei die metallische Schirmschicht für jede Durchkontaktierung (10) einen Durchbruch mit einem Radius aufweist,
**dadurch gekennzeichnet, dass** eine hülsenförmige Ringelektrode mit dem Radius des Durchbruchs koaxial um die Durchkontaktierung (10) über eine Länge von mindestens 50%, vorzugsweise nicht weniger als 75% der Leiterplattenstärke in die Leiterplatte geführt ist um die Durchkontaktierung gegen HF-Störungen zu schirmen, wobei der Radius der Ringelektrode so gewählt ist, dass die Kapazität zwischen der Ringelektrode und dem Leiter der Durchkontaktierung (10) mit der Zündschutzart "eigensicher" (Ex-i) vereinbar ist.

2. Messumformer nach Anspruch 1, wobei die Schirmung mindestens eine elektrisch leitende Hülse aufweist, welche die mindestens eine elektrische Durchkontaktierung umgibt, von der Durchkontaktierung galvanisch getrennt und mit der Schirmschicht im galvanischen Kontakt ist, wobei die Hülse insbesondere in den Schirmträger eingebettet ist.

3. Messumformer nach einem der vorhergehenden Ansprüche, wobei der mindestens eine Hochfrequenzfilter an dem Schirmträger angeordnet ist, wobei, die erste elektronische Schaltung über den Hochfrequenzfilter mit der elektrischen Durchkontaktierung verbunden ist, wobei der Abstand des Hochfrequenzfilters von der Durchkontaktierung nicht mehr als 2 cm, vorzugsweise nicht mehr al 1,5 cm und besonders bevorzugt nicht mehr als 1 cm beträgt.

4. Messumformer nach einem der Ansprüche 1 bis 3, wobei der Schirmträger ein separates, plattenförmiges Bauteil ist, welches in die Gehäuseanordnung eingebaut ist.

5. Messumformer nach einem der vorhergehenden Ansprüche wobei die Gehäuseanordnung einen Innenraum aufweist, der in einer Ebene, in welcher die Schirmung angeordnet ist, eine lichte Querschnittsfläche aufweist, die zu nicht weniger als 75% vorzugsweise nicht weniger als 80% weiter bevorzugt nicht weniger als 90% und besonders bevorzugt mindestens 98% von der Schirmung abgedeckt ist.

6. Messumformer nach einem der vorhergehenden Ansprüche, wobei die metallische Schirmschicht im galvanischen Kontakt mit dem elektrisch leitenden Werkstoff des Gehäuses steht.

7. Messumformer nach einem der vorhergehenden nach Ansprüche, wobei der mindestens eine Hochfrequenzfilter mindestens ein LC-Glied umfasst.

8. Messumformer nach einem der vorhergehenden Ansprüche, wobei die Gehäuseanordnung ein erstes Modulgehäuse und ein zweites Modulgehäuse aufweist, die miteinander verbunden sind,
wobei das erste Modulgehäuse den Sensor, die erste elektronische Schaltung und die Schirmung enthält,
wobei das zweite Modulgehäuse die zweite elektronische Schaltung enthält, wobei das zweite Modulgehäuse eine Öffnung aufweist, über weiche die erste elektronische Schaltung mit der zweiten elektronischen Schaltung verbunden ist

9. Messumformer nach Anspruch 8, wobei ein Endabschnitt des ersten Modulgehäuses in die Öffnung des zweiten Modulgehäuses hineinragt und mit einem die Öffnung umgebenden Halsbereich des zweiten Modulgehäuses verbunden ist.

10. Messumformer nach einem der vorhergehenden Ansprüche, wobei die Gehäuseanordnung und die Schirmschicht einen Faradayschen Käfig um die erste elektronische Schaltung bilden.

11. Messumformer nach einem der vorhergehenden Ansprüche, wobei der Sensor, einen Drucksensor, einen Füllstandssensor, einen Temperatursensor, einen Durchflusssensor, einen Feuchtesensor, einen Dichtesensor, einen Zähigkeitssensor, einen Leitfähigkeitssensor, einen potentiometrischen Sensor, einen amperometrischen Sensor, oder einen optischen Sensor umfasst.

## Claims

1. Transmitter designed to provide a measured value at least of a measured variable to a control system, comprising:
a sensor (15, 16) with an electrical transducer designed to output a primary signal that depends on the current value of the measured variable;
a first electronic circuit (14), designed to drive the transducer, process the primary signal, and output an intermediate signal that depends on the primary signal;
a second electronic circuit (6) designed to feed the first electronic circuit, process the intermediate signal, and generate a signal representing the measured value of the measured variable, wherein the second electronic circuit has a signal output designed to output the signal to connection cables;
a housing configuration (1a, 1b, 2), which features at least one electrically conductive material, particularly a metal material,
wherein the first electronic circuit (14) has at least a first circuit carrier, and the second electronic circuit has at least a second circuit carrier, and wherein the first and the second electronic circuit are positioned at a distance from one another in the housing configuration (1a, 1b, 2); and
an electrically conductive shield (9) and a high-frequency filter (11) designed to protect against RF interference which could penetrate into the housing configuration (1a, 1b, 2) via the connecting cables (4) :
wherein the electrically conductive shield (9) and the high-frequency filters (11) are arranged between the first circuit carrier and the second circuit carrier,
wherein the shield comprises an electrically isolating shield carrier with a metal shield layer and wherein the high-frequency filter is separated from the second electronic circuit by the shield layer,
wherein the shield carrier has at least a through-connection by means of which the second electronic circuit is connected to the first electronic circuit, wherein at least one of the electrical through-connections (10) is galvanically isolated from the metal shield layer and is surrounded in an annular manner,
wherein the capacitance between the through-connection and the shield is not greater than 1 nF,
wherein the metal shield layer for each through-connection (10) has a passage with a radius,
**characterized in that**
a sleeve-shaped ring electrode with the radius of the passage is coaxially routed around the through-connection (10) in the printed circuit board over a length of at least 50 %, preferably not less than 75 % of the thickness of the printed circuit board, in order to shield the through-connection against RF interference, wherein the radius of the ring electrode is selected in such a way that the capacitance between the ring electrode and the conductor of the through-connection (10) is compatible with the « intrinsically safe » (Ex-i) type of protection.

2. Transmitter as claimed in Claim 1, wherein the shield has at least an electrically conductive sleeve which surrounds the at least one electrical through-connection, is galvanically isolated from the through-connection and is in galvanic contact with the shield layer, wherein the sleeve is particularly embedded in the shield carrier.

3. Transmitter as claimed in one of the previous claims, wherein the at least one high-frequency filter is arranged on the shield carrier, wherein the first electronic circuit is connected to the electric through-connection via the high-frequency filter, wherein the distance of the high-frequency filter in relation to the through-connection is not more than 2 cm, preferably not more than 1.5 cm and particularly preferably not more than 1 cm.

4. Transmitter as claimed in one of the Claims 1 to 3, wherein the shield carrier is a separate plate-shaped component, which is incorporated into the housing configuration.

5. Transmitter as claimed in one of the previous claims, wherein the housing configuration has an interior area, wherein in a plane in which the shield is arranged said interior area has a cross-sectional area which is covered by at least 75 % by the shield, preferably by at least 80 %, more preferably by at least 90 % and particularly preferably by at least 98 %.

6. Transmitter as claimed in one of the previous claims, wherein the metal shield layer is in galvanic contact with the electrically conductive material of the housing.

7. Transmitter as claimed in one of the previous claims, wherein the at least one high-frequency filter comprises at least one LC element.

8. Transmitter as claimed in one of the previous claims, wherein the housing configuration has a first module housing and a second module housing, which are interconnected,
wherein the first module housing contains the sensor, the first electronic circuit and the shield,
wherein the second module housing contains the second electronic circuit, wherein the second module housing has an opening by means of which the first electronic circuit is connected to the second electronic circuit.

9. Transmitter as claimed in Claim 8, wherein an end section of the first module housing projects into the opening of the second module housing and is connected to a neck area of the second module housing that surrounds the opening.

10. Transmitter as claimed in one of the previous claims, wherein the housing configuration and the shield layer form a Faraday cage around the first electronic circuit.

11. Transmitter as claimed in one of the previous claims, wherein the sensor comprises a pressure sensor, a level sensor, a temperature sensor, a flow sensor, a humidity sensor, a density sensor, a viscosity sensor, a conductivity sensor, a potentiometric sensor, an amperometric sensor or an optical sensor.

## Revendications

1. Transmetteur destiné à la mise à disposition d'une valeur mesurée d'au moins une grandeur mesurée sur un système de contrôle-commande, comprenant :
un capteur (15, 16) avec un convertisseur électrique destiné à délivrer un signal primaire dépendant de la valeur actuelle de la grandeur mesurée ;
un premier circuit électronique (14), destiné à attaquer le convertisseur pour le traitement du signal primaire et pour l'émission d'un signal intermédiaire dépendant du signal primaire ;
un deuxième circuit électronique (6) destiné à alimenter le premier circuit électronique et à traiter le signal intermédiaire, ainsi qu'à générer un signal représentant la valeur mesurée de la grandeur mesurée, le deuxième circuit électronique comportant une sortie de signal destinée à acheminer le signal à des câbles de raccordement ;
une configuration de boîtier (1a, ab, 2), laquelle comprend au moins un matériau électriquement conducteur, notamment un matériau métallique,
le premier circuit électronique (14) comportant au moins un premier support de circuit, et le deuxième circuit électronique comportant au moins un deuxième support de circuit, et le premier et le deuxième circuit électronique étant positionnés à distance l'un de l'autre dans la configuration de boîtier (1a, 1b, 2) ; et
un blindage électriquement conducteur (9) et un filtre haute fréquence (11) destiné à la protection contre les perturbations HF qui peuvent pénétrer à l'intérieur de la configuration de boîtier (1a, 1b, 2) par l'intermédiaire des câbles de raccordement (4) :
le blindage électriquement conducteur (9) et le filtre haute fréquence (11) étant disposés entre le premier support de circuit et le deuxième support de circuit,
le blindage comprenant un support de blindage électriquement isolant avec une couche de blindage métallique, et le filtre haute fréquence étant séparé du deuxième circuit électronique par la couche de blindage,
le support de blindage présentant au moins un contact de passage, par l'intermédiaire duquel le deuxième circuit électronique est relié avec le premier circuit électronique, au moins l'un des contacts de passage (10) étant séparé galvaniquement de la couche de blindage métallique et entouré sous forme annulaire,
la capacité entre le contact de passage et le blindage n'étant pas supérieure à 1 nF,
la couche de blindage métallique comprenant pour chaque contact de passage (10) un passage présentant un rayon,
**caractérisé**
**en ce qu'**une électrode annulaire en forme de douille est guidée avec le rayon du passage, coaxialement autour du contact de passage (10) sur une longueur d'au moins 50 %, de préférence d'au moins 75 % de l'épaisseur de la carte de circuit imprimé, afin de protéger le contact de passage contre les perturbations HF, le rayon de l'électrode annulaire étant choisi de telle sorte que la capacité entre l'électrode annulaire et le conducteur du contact de passage (10) est compatible avec le mode de protection à « sécurité intrinsèque » (Ex-i).

2. Transmetteur selon la revendication 1, pour lequel le blindage présente au moins une douille électriquement conductrice, laquelle douille entoure l'au moins un contact de passage électrique, est isolée galvaniquement du contact de passage et est en contact galvanique avec la couche de blindage, la douille étant notamment incorporée dans le support de blindage.

3. Transmetteur selon l'une des revendications précédentes, pour lequel l'au moins un filtre haute fréquence est disposé sur le support de blindage, le premier circuit électronique étant relié à travers le filtre haute fréquence avec le contact de passage électrique, la distance du filtre haute fréquence par rapport au contact de passage étant au maximum de 2 cm, de préférence au maximum de 1,5 cm et particulièrement de préférence au maximum de 1 cm.

4. Transmetteur selon l'une des revendications 1 à 3, pour lequel le support de blindage est un composant séparé, en forme de plaque, lequel composant est intégré dans la configuration de boîtier.

5. Transmetteur selon l'une des revendications précédentes, pour lequel la configuration de boîtier présente un espace intérieur, lequel espace intérieur présente, dans un plan dans lequel est disposé le blindage, une superficie de section utile qui est recouverte à au moins 75 %, de préférence à au moins 80 %, encore de préférence à au moins 90 % et particulièrement de préférence à au moins 98 % par le blindage.

6. Transmetteur selon l'une des revendications précédentes, pour lequel la couche de blindage métallique est en contact galvanique avec le matériau électriquement conducteur du boîtier.

7. Transmetteur selon l'une des revendications précédentes, pour lequel l'au moins un filtre haute fréquence comprend au moins un circuit LC.

8. Transmetteur selon l'une des revendications précédentes, pour lequel la configuration de boîtier présente un premier boîtier modulaire et un deuxième boîtier modulaire, qui sont reliés entre eux,
le premier boîtier modulaire contenant le capteur, le premier circuit électronique et le blindage,
le deuxième boîtier modulaire contenant le deuxième circuit électronique, le deuxième boîtier modulaire présentant une ouverture, à travers laquelle le premier circuit électronique est relié avec le deuxième circuit électronique.

9. Transmetteur selon la revendication 8, pour lequel la partie finale du premier boîtier modulaire pénètre dans l'ouverture du deuxième boîtier modulaire et est reliée avec une partie de col du deuxième boîtier modulaire, entourant l'ouverture.

10. Transmetteur selon l'une des revendications précédentes, pour lequel la configuration de boîtier et la couche de blindage forment une cage de Faraday autour du premier circuit électronique.

11. Transmetteur selon l'une des revendications précédentes, pour lequel le capteur comprend un capteur de pression, un capteur de niveau, un capteur de température, un capteur de débit, un capteur d'humidité, un capteur de densité, un capteur de viscosité, un capteur de conductivité, un capteur potentiométrique, un capteur ampérométrique ou un capteur optique.
